# EUROPEAN PATENT APPLICATION

(11) **EP 2 922 106 A1**
(43) Date of publication of application: **23.09.2015**
(21) Application number: 15156297.2
(22) Date of filing: 24.02.2015
(51) Int. Cl.: H01L 39/14, H01L 39/24

(54) **Superconducting member and method for manufacturing the same**

(30) Priority: 17.03.2014 JP 2014053268
(71) Applicant: Kabushiki Kaisha Toshiba, Tokyo 105-8001 (JP)
(72) Inventor: Nakayama, Kohei, Tokyo, 105-8001 (JP); Kawaguchi, Tamio, Tokyo, 105-8001 (JP); Ikeuchi, Hiroaki, Tokyo, 105-8001 (JP); Kayano, Hiroyuki, Tokyo, 105-8001 (JP)
(74) Representative: Hoffmann Eitle

(57) **Abstract**

According to one embodiment, a superconducting member (110, 110a) includes a superconducting layer (20), a foundation layer (10), and an intermediate layer (30). The superconducting layer (20) is made of an oxide including Cu and Ba. The foundation layer (10) is made of cerium oxide. The intermediate layer (30) is provided between the foundation layer (10) and the superconducting layer (20), and is made of BaₓCa_{y}CeO₃ (0.6 < x < 0.8 and 0.2 < *y* < 0.4).

## Description

### FIELD

Embodiments described herein relate generally to a superconducting member and a method for manufacturing the same.

### BACKGROUND

For example, there are expectations for applications of a superconducting member in microwave devices, etc. It is desirable to improve the characteristics of such a superconducting member. To improve the characteristics, it is desirable to improve the crystallinity of the superconducting member.

### BRIEF DESCRIPTION OF THE DRAWINGS

FIG. 1 is a schematic cross-sectional view illustrating a superconducting member according to a first embodiment;
FIG. 2 is a graph of a characteristic of the superconducting member according to the first embodiment;
FIG. 3A and FIG. 3B are graphs of characteristics of the superconducting member according to the first embodiment;
FIG. 4 is a schematic cross-sectional view illustrating the superconducting member according to the first embodiment;
FIG. 5 is a schematic cross-sectional view illustrating a superconducting member according to a second embodiment;
FIG. 6A and FIG. 6B are graphs of characteristics of the superconducting member according to the second embodiment;
FIG. 7 is a flowchart illustrating a method for manufacturing a superconducting member according to a third embodiment; and
FIG. 8 is a schematic view illustrating an electronic device using the superconducting member according to the embodiment.

### DETAILED DESCRIPTION

According to one embodiment, a superconducting member includes a superconducting layer, a foundation layer, and an intermediate layer. The superconducting layer is made of an oxide including Cu and Ba. The foundation layer is made of cerium oxide. The intermediate layer is provided between the foundation layer and the superconducting layer, and is made of Ba*ₓ*Ca*_{y}*CeO₃ (0.6 < *x* < 0.8 and 0.2 < *y* < 0.4).

According to one embodiment, a superconducting member includes a substrate, a superconducting layer, and an intermediate layer. The substrate is made of MgO. The superconducting layer is made of an oxide including Cu and Ba. The intermediate layer is provided between the substrate and the superconducting layer, and is made of Ba*ₓ*Ca*_{y}*CeO₃ (0.6 < *x* < 0.8 and 0.2 < *y* < 0.4).

According to one embodiment, a method for manufacturing a superconducting member is disclosed. The method can include forming a foundation layer of cerium oxide on a substrate of a dielectric, and forming an intermediate layer of Ba*ₓ*Ca*_{y}*CeO₃ (0.6 < *x* < 0.8 and 0.2 < *y* < 0.4) on the foundation layer. In addition, the method can include forming a superconducting layer of an oxide including Cu and Ba on the intermediate layer.

Various embodiments will now be described hereinafter with reference to the accompanying drawings.

The drawings are schematic or conceptual; and the relationships between the thicknesses and widths of portions, the proportions of sizes between portions, etc., are not necessarily the same as the actual values thereof. Further, the dimensions and/or the proportions may be illustrated differently between the drawings, even in the case where the same portion is illustrated.

In the drawings and the specification of the application, components similar to those described in regard to a drawing thereinabove are marked with like reference numerals, and a detailed description is omitted as appropriate.

### First embodiment

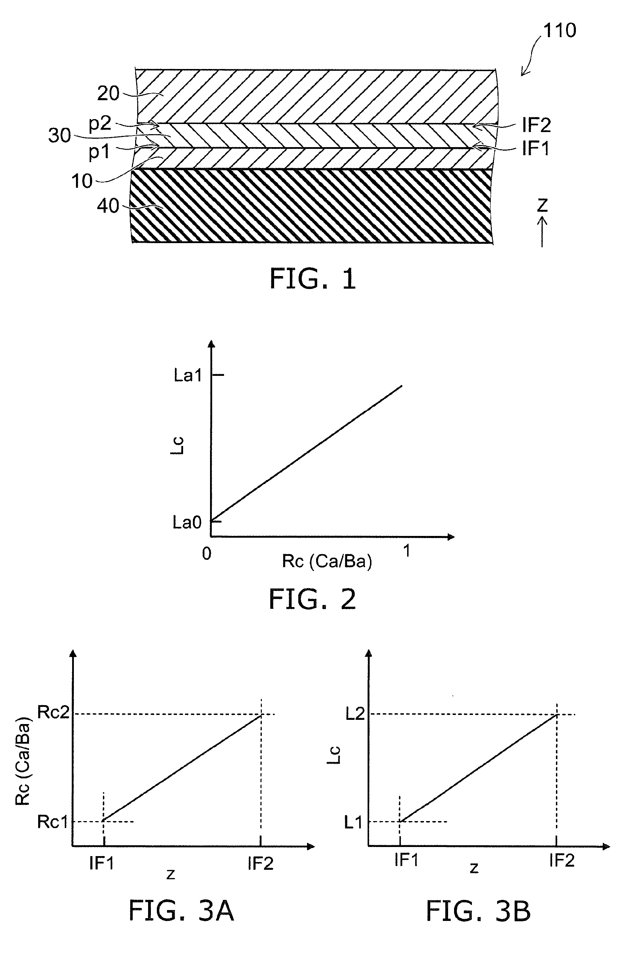

FIG. 1 is a schematic cross-sectional view illustrating a superconducting member according to a first embodiment.

As shown in FIG. 1, the superconducting member 110 according to the embodiment includes a foundation layer 10, a superconducting layer 20, and an intermediate layer 30 (for example, an intermediate region). The intermediate layer 30 is provided between the foundation layer 10 and the superconducting layer 20.

The foundation layer 10 includes, for example, cerium oxide (ceria). The superconducting layer 20 includes, for example, an oxide including Cu and Ba.

For example, the superconducting layer 20 is a CuBa₂Ca₃Cu₄O_{12-*z*} (0 < *z* < 1) layer. In other words, the superconducting layer 20 includes Cu1234.

The superconducting layer 20 may be a ReBa₂Cu₃O_{7-δ} (0 < δ < 0.5) layer. Re is not more than three selected from La, Y, Sm, Eu, Gd, Dy, Yb, Nd, Ho, and Er. In other words, the superconducting layer 20 includes Re123.

The intermediate layer 30 includes BaₓCa_{y}CeO₃ (0.6 < *x* < 0.8 and 0.2 < *y* < 0.4). *x* + *y* = 1.

The intermediate layer 30 has, for example, a layer configuration. The intermediate layer 30 is continuous. The superconducting layer 20 is separated from the foundation layer 10 by the intermediate layer 30. For example, the superconducting layer 20 does not contact the foundation layer 10. The intermediate layer 30 contacts the foundation layer 10. The intermediate layer 30 contacts the superconducting layer 20.

The superconducting member 110 may further include a substrate 40. The substrate 40 is a dielectric. The substrate 40 is, for example, a sapphire substrate.

The foundation layer 10 is formed on the substrate 40; the intermediate layer 30 is formed on the foundation layer 10; and the superconducting layer 20 is formed on the intermediate layer 30. In other words, the foundation layer 10 is disposed between the substrate 40 and the intermediate layer 30.

The direction from the foundation layer 10 toward the superconducting layer 20 is taken as a stacking direction (a Z-axis direction). The substrate 40, the foundation layer 10, the intermediate layer 30, and the superconducting layer 20 are stacked in this order along the Z-axis direction.

The thickness of the substrate 40 is, for example, not less than 200 micrometers (µm) and not more than 600 µm.

The thickness of the foundation layer 10 is, for example, not less than 50 nm and not more than 200 nm.

The thickness of the intermediate layer 30 is, for example, not less than 50 nm and not more than 500 nm. The thickness of the intermediate layer 30 is, for example, not less than 0.5 times and not more than 3 times the thickness of the foundation layer 10. The total thickness of the foundation layer 10 and the intermediate layer 30 is, for example, not less than 100 nm and not more than 500 nm.

The thickness of the superconducting layer 20 is, for example, not less than 300 nm and not more than 10 µm.

In the embodiment, the intermediate layer 30 of BaₓCa_{y}CeO₃ (0.62 < *x* < 0.72 and 0.28 < *y* < 0.38) is provided between the foundation layer 10 and the superconducting layer 20. The intermediate layer 30 has a perovskite structure. The crystal structure of the intermediate layer 30 is stable. Therefore, degradation of the characteristics of the superconducting layer 20 due to fluctuation of the composition of the superconducting layer 20 when forming the superconducting layer 20 on the intermediate layer 30 can be suppressed.

For example, there is a reference example in which the superconducting layer 20 that includes Ba is formed directly on the foundation layer 10 of cerium oxide without the intermediate layer 30 being provided. In the reference example, in the case where the formation temperature of the superconducting layer 20 is high, reactions occur between the Ba and the cerium oxide; and compounds (e.g., barium cerate) are produced easily. The lattice constant of such a compound is greatly different from the lattice constant of cerium oxide. The lattice constant of the compound also is greatly different from the lattice constant of the superconducting layer 20 having a c-axis orientation. Therefore, the compound grows in granular configurations and obstructs the stacking growth of the superconducting layer 20. The compound assimilates the Ba inside the superconducting layer 20. The composition of the superconducting layer 20 shifts. Therefore, the characteristics of the superconducting layer 20 degrade.

In the case where the superconducting layer 20 is formed at a low temperature to suppress this problem, it is difficult to obtain good crystallinity of the superconducting layer 20.

In the case where the c-axis orientation growth of the superconducting layer 20 is performed directly on the (100) plane of the foundation layer 10 of cerium oxide, the a-axis direction of the unit lattice of the superconducting layer 20 is rotated 45° with respect to the a-axis direction of the unit lattice of the cerium oxide layer which is the foundation layer 10 due to the difference between the crystal structures. In such a case, the value of 2^{1/2} times the length of the lattice of the a-axis is used as the lattice constant of the superconducting layer 20 when studying the lattice matching. This value is called the "2^{1/2}-times lattice constant." The value of 2^{-1/2} times the length of the lattice of the a-axis is called the "2^{-1/2}-times lattice constant."

Considering this aspect, there is a difference between the lattice constant of cerium oxide and the 2^{1/2}-times lattice constant of the superconducting layer 20. Namely, the 2^{1/2}-times lattice constant of the superconducting layer 20 is larger than the lattice constant of cerium oxide. Therefore, in the reference example in which the superconducting layer 20 is formed directly on the foundation layer 10 of cerium oxide, there is a limit to improving the crystallinity of the superconducting layer 20 due to mismatch of the lattices of the foundation layer 10 and the superconducting layer 20. In the reference example, it is difficult to obtain crystallinity corresponding to the superconductor in the bulk state.

By using the intermediate layer 30 in the embodiment, the reactions between the foundation layer 10 and the Ba inside the superconducting layer 20 can be suppressed even in the case where the superconducting layer 20 is formed at a high temperature. The production of compounds such as those recited above can be suppressed. High crystallinity of the superconducting layer 20 is obtained.

The lattice constant of the intermediate layer 30 is between the lattice constant of cerium oxide and the lattice constant of the superconducting layer 20. Mismatch between the lattice constants is suppressed. Thereby, high crystallinity of the superconducting layer 20 is obtained. Thereby, the characteristics of the superconducting layer 20 can be improved.

FIG. 2 is a graph of a characteristic of the superconducting member according to the first embodiment.

FIG. 2 illustrates the lattice constant of the intermediate layer 30 when the composition ratio of Ba and Ca of the intermediate layer 30 is changed. The horizontal axis is a ratio Rc of the concentration of Ca to the concentration of Ba in the intermediate layer 30. The vertical axis is a lattice constant Lc of the intermediate layer 30.

As illustrated in FIG. 2, the lattice constant Lc of the intermediate layer 30 changes as the ratio Rc of the concentration of Ca to the concentration of Ba in the intermediate layer 30 changes. The lattice constant Lc of the intermediate layer 30 is large when the ratio Rc is high. A lattice constant La1 is 0.600 nm when the ratio Rc is 1. A lattice constant La0 is 0.440 nm when the ratio Rc is 0.

In the embodiment, the ratio Rc of the concentration of Ca to the concentration of Ba in the intermediate layer 30 is, for example, not less than 0.43 and not more than 0.50. In such a case, the lattice constant Lc of the intermediate layer 30 is not less than about 0.538 nm and not more than 0.548 nm.

On the other hand, the lattice constant of cerium oxide is 0.541 nm. In the case where CuBa₂Ca₃Cu₄O_{12-*z*} (0 < *z* < 1) is used as the superconducting layer 20, the 2^{1/2}-times lattice constant of the superconducting layer 20 is 0.546 nm. In the case where ReBa₂Cu₃O_{7-δ} (0 *< δ* < 0.5) is used as the superconducting layer 20, the 2^{1/2}-times lattice constant of the superconducting layer 20 is 0.545 nm.

Accordingly, the lattice constant Lc of the intermediate layer 30 is set to be between the lattice constant of the foundation layer 10 and the 2^{1/2}-times lattice constant of the superconducting layer 20 by setting the ratio Rc of the concentration of Ca to the concentration of Ba in the intermediate layer 30 to be not less than 0.43 and not more than 0.50. Thereby, the lattice mismatch is suppressed. The crystallinity of the superconducting layer 20 improves; and the superconducting characteristics improve.

The ratio Rc of the concentration of Ca to the concentration of Ba in the intermediate layer 30 also may be set to change in the stacking direction (the direction from the foundation layer 10 toward the superconducting layer 20).

For example, as illustrated in FIG. 1, the intermediate layer 30 includes a first region p1 and a second region p2. The second region p2 is provided between the first region p1 and the superconducting layer 20. The first region p1 includes, for example, a first interface region IF1 between the foundation layer 10 and the intermediate layer 30. The second region p2 includes a second interface region IF2 between the intermediate layer 30 and the superconducting layer 20.

The ratio Rc of the concentration of Ca to the concentration of Ba in the second region p2 may be set to change as the ratio Rc of the concentration of Ca to the concentration of Ba in the first region p1 changes. For example, the ratio Rc of the concentration of Ca to the concentration of Ba in the second region p2 is set to be higher than the ratio Rc of the concentration of Ca to the concentration of Ba in the first region p1. Thereby, the lattice constant of the second region p2 is larger than the lattice constant of the first region p1.

In other words, in the first region p1, the lattice constant Lc of the intermediate layer 30 corresponds to the lattice constant of the foundation layer 10. In the second region p2, the lattice constant Lc of the intermediate layer 30 corresponds to the 2^{1/2}-times lattice constant of the superconducting layer 20. Thereby, higher crystallinity is obtained.

FIG. 3A and FIG. 3B are graphs of characteristics of the superconducting member according to the first embodiment.

FIG. 3A illustrates the change of the ratio Rc of the concentration of Ca to the concentration of Ba in the intermediate layer 30. FIG. 3B illustrates the change of the lattice constant Lc of the intermediate layer 30. In these drawings, the horizontal axis is a position z in the stacking direction. The vertical axis of FIG. 3A is the ratio Rc. The vertical axis of FIG. 3B is the lattice constant Lc.

As shown in FIG. 3A, the ratio Rc is set to change along the stacking direction. For example, the ratio Rc in the first interface region IF1 (the first region p1) is set to a first ratio Rc1. The ratio Rc in the second interface region IF2 (the second region p2) is set to a second ratio Rc2. The second ratio Rc2 is higher than the first ratio Rc1. As a result, the lattice constant Lc changes.

Namely, as shown in FIG. 3B, for example, the lattice constant Lc of the first interface region IF1 (the first region p1) is set to a first lattice constant L1. The lattice constant Lc of the second interface region IF2 (the second region p2) is set to a second lattice constant L2. The second lattice constant L2 is larger than the first lattice constant L1.

For example, the difference between the first lattice constant L1 and the lattice constant of the foundation layer 10 is set to be not less than -0.5% and not more than 0.5% of the lattice constant of the foundation layer 10. For example, the difference between the second lattice constant L2 and the 2^{1/2}-times lattice constant of the superconducting layer 20 is set to be not less than -0.5% and not more than 0.5% of the 2^{1/2}-times lattice constant of the superconducting layer 20.

For example, the ratio Rc (the second ratio Rc2) of the concentration of Ca to the concentration of Ba in the second region p2 is not less than 0.46 and not more than 0.50. For example, the ratio Rc (the first ratio Rc1) of the concentration of Ca to the concentration of Ba in the first region p1 is not less than 0.43 and not more than 0.47.

Higher crystallinity of the superconducting layer 20 is obtained by setting the ratio Rc of the concentration of Ca to the concentration of Ba to change in the intermediate layer 30.

Internal strain of the superconducting layer 20 can be relaxed by causing the lattice constant Lc of the intermediate layer 30 to match the lattice constant of the superconducting layer 20. Thereby, high-quality crystallinity approaching the bulk crystallinity is obtained in the superconducting layer 20.

By setting the composition of the intermediate layer 30 to have a gradient as recited above, the intermediate layer 30 can be formed to have a layer configuration in a good state. Also, the thickness of the superconducting layer 20 can be increased. Thereby, the characteristics of the superconducting layer 20 can be improved further.

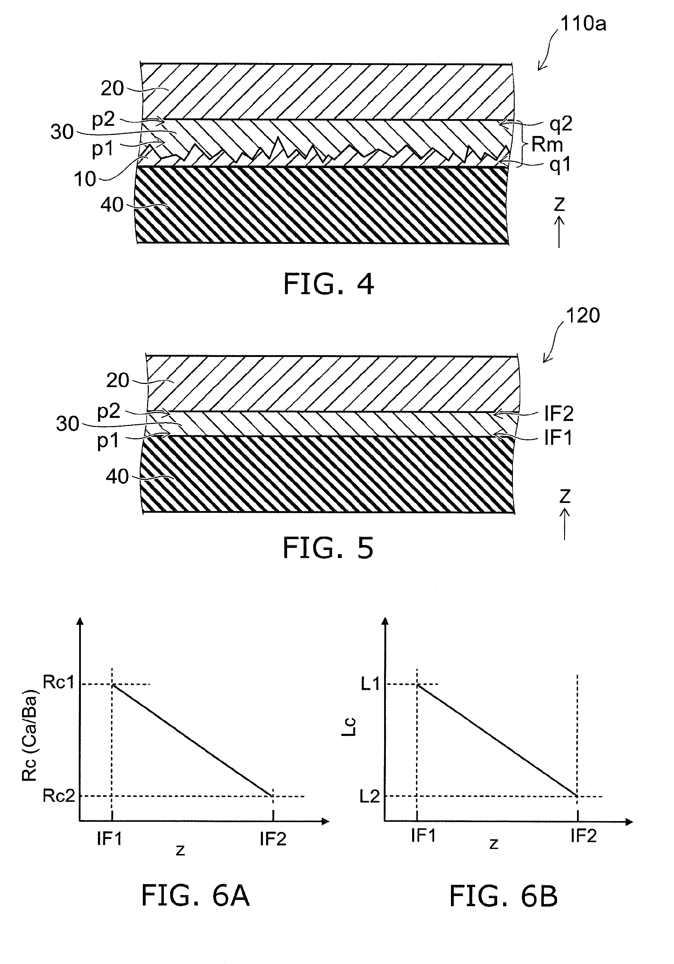

FIG. 4 is a schematic cross-sectional view illustrating the superconducting member according to the first embodiment.

As shown in FIG. 4, the foundation layer 10 may have an uneven configuration. For example, the superconducting member 110a according to the embodiment includes the superconducting layer 20 and a foundation region Rm. The foundation region Rm is provided between the substrate 40 and the superconducting layer 20.

The foundation region Rm includes a first portion q1 (a substrate-side region) and a second portion q2 (a superconducting layer-side region). The second portion q2 is disposed between the first portion q1 and the superconducting layer 20.

The first portion q1 includes, for example, cerium oxide. The second portion q2 includes Ba*ₓ*Ca*_{y}*CeO₃ (0.6 < *x* < 0.8 and 0.2 < *y* < 0.4). For example, the first portion q1 corresponds to the foundation layer 10. The second portion q2 corresponds to the intermediate layer 30.

For example, the concentration of cerium in the first portion q1 is higher than the concentration of cerium in the second portion q2. The concentration of barium in the second portion q2 is higher than the concentration of barium in the first portion q1.

In the superconducting member 110a as well, the crystallinity of the superconducting layer 20 can be improved; and a superconducting member having good characteristics can be provided.

In the example as well, the ratio Rc may be set to change along the stacking direction in the second portion q2.

Examples of characteristics of the superconducting member will now be described.

In first to eighth samples described below, the foundation layer 10 (cerium oxide) is formed on the substrate 40 (sapphire); and the superconducting layer 20 is formed on the foundation layer 10. The intermediate layer 30 is provided in some cases; and the intermediate layer 30 is not provided in some cases.

In the following samples, the formation of the intermediate layer 30 includes laser ablation. Each of the intermediate layers 30 is formed in a reduced pressure oxygen atmosphere of 100 pascals (Pa) or less using a source material target that matches the composition of each layer.

In each of the samples, the formation temperature, partial pressure of oxygen, repetition frequency of the laser, and laser power are different between the foundation layer 10, the intermediate layer 30, and the superconducting layer 20. After forming the superconducting layer 20, the temperature is abruptly decreased to 200°C in a short period of time; and simultaneously, the pressure is abruptly increased to 1000 hectopascals (hPa).

In the first sample, the superconducting layer 20 (Y123) is formed on the foundation layer 10 without forming the intermediate layer. The critical current density of the first sample is 3.1×10⁶ (A_{/}cm²).

In the second sample, a SrSnO₃ layer is formed on the foundation layer 10 instead of the intermediate layer; and a superconducting layer 20 (Y123) is formed on the SrSnO₃ layer. The critical current density of the second sample is 0.4×10⁶ (A_{/}cm²).

In the third sample, Ba*ₓ*Ca*_{y}*CeO₃ (0.6 < *x* < 0.8 and 0.2 < *y* < 0.4) is formed as the intermediate layer 30 on the foundation layer 10. *x* is 0.68; and *y* is 0.32. The superconducting layer 20 (Y123) is formed on the intermediate layer 30. The critical current density of the third sample is 4.2×10⁶ (A_{/}cm²).

In the fourth sample, Ba*ₓ*Ca*_{y}*CeO₃ (0.6 < *x* < 0.8 and 0.2 < *y* < 0.4) that has a gradient composition is formed as the intermediate layer 30 on the foundation layer 10. *x* is set to change from 0.69 to 0.68; and in conjunction, *y* is set to change from 0.31 to 0.32. The superconducting layer 20 (Y123) is formed on the intermediate layer 30. The critical current density of the fourth sample is 4.8×10⁶ (A_{/}cm²).

In the fifth sample, the superconducting layer 20 (Cu1234) is formed on the foundation layer 10 without forming the intermediate layer. The critical current density of the fifth sample is 0.3×10⁶ (A_{/}cm²).

In the sixth sample, a SrSnO₃ layer is formed on the foundation layer 10 instead of the intermediate layer; and the superconducting layer 20 (Cu1234) is formed on the SrSnO₃ layer. The critical current density of the sixth sample is 0×10⁶ (A/cm²).

In the seventh sample, BaₓCa_{y}CeO₃ (0.6 < *x* < 0.8 and 0.2 < *y* < 0.4) is formed on the foundation layer 10 as the intermediate layer 30. *x* is 0.67; and *y* is 0.33. The superconducting layer 20 (Cu1234) is formed on the intermediate layer 30. In the seventh sample, the critical current density is 5.3×10⁶ (A_{/}cm²).

In the eighth sample, BaₓCa_{y}CeO₃ (0.6 < *x* < 0.8 and 0.2 < *y* < 0.4) that has a gradient composition is formed as the intermediate layer 30 on the foundation layer 10. *x* is set to change from 0.69 to 0.67; and in conjunction, *y* is set to change from 0.31 to 0.33. The superconducting layer 20 (Cu1234) is formed on the intermediate layer 30. The critical current density of the eighth sample is 6.2×10⁶ (A/cm²).

A high critical current density is obtained by using the intermediate layer 30 according to the embodiment.

In the embodiment, the stacked structural body of the foundation layer 10, the intermediate layer 30, and the superconducting layer 20 may be provided at both surfaces of the substrate 40.

### Second embodiment

FIG. 5 is a schematic cross-sectional view illustrating a superconducting member according to a second embodiment.

As shown in FIG. 5, the superconducting member 120 according to the embodiment includes the substrate 40, the superconducting layer 20, and the intermediate layer 30. The intermediate layer 30 is provided between the substrate 40 and the superconducting layer 20.

The substrate 40 includes MgO. The superconducting layer 20 includes an oxide including Cu and Ba. In such a case as well, CuBa₂Ca₃Cu₄O_{12-*z*} (0 < *z* < 1) is used as the superconducting layer 20. Or, ReBa₂Cu₃O_{7-δ} (0 < δ < 0.5) may be used as the superconducting layer 20. In such a case as well, Re is not more than three selected from La, Y, Sm, Eu, Gd, Dy, Yb, Nd, Ho, and Er.

The intermediate layer 30 includes Ba*ₓ*Ca*_{y}*CeO₃ (0.6 < *x* < 0.8 and 0.2 < *y* < 0.4).

By providing the intermediate layer 30, the mismatch of the lattice constants between the substrate 40 and the superconducting layer 20 can be relaxed. Thereby, high crystallinity of the superconducting layer 20 is obtained.

The lattice constant of the substrate 40 (MgO) is 0.421 nm. In the example, the lattice constant of the superconducting layer 20 is smaller than the lattice constant of the substrate 40. The 2^{-1/2}-times lattice constant of the intermediate layer 30 may be adjusted to match these lattice constants.

For example, the interface between the substrate 40 and the intermediate layer 30 is the first interface region IF1. The interface between the intermediate layer 30 and the superconducting layer 20 is the second interface region IF2. The second ratio Rc2 in the second interface region IF2 (the second region p2) is set to change as the first ratio Rc1 in the first interface region IF1 (the first region p1) changes.

FIG. 6A and FIG. 6B are graphs of characteristics of the superconducting member according to the second embodiment.

FIG. 6A illustrates the change of the ratio Rc of the concentration of Ca to the concentration of Ba in the intermediate layer 30. FIG. 6B illustrates the change of the 2^{-1/2}-times lattice constant Lc in the intermediate layer 30.

As shown in FIG. 6A, for example, the second ratio Rc2 in the second interface region IF2 (the second region p2) is set to be lower than the first ratio Rc1 in the first interface region IF1 (the first region p1).

As shown in FIG. 6B, for example, the second 2^{-1/2}-times lattice constant L2 in the second interface region IF2 (the second region p2) is set to be smaller than the first 2^{-1/2}-times lattice constant L1 in the first interface region IF1 (the first region p1).

For example, the first 2^{-1/2}-times lattice constant L1 is set to correspond to the lattice constant of the substrate 40. The second 2^{-1/2}-times lattice constant L2 is set to correspond to the lattice constant of the superconducting layer 20. For example, the first 2^{-1/2}-times lattice constant L1 is set so that the difference between the lattice constant of the substrate 40 is not less than -0.5% and not more than 0.5% of the lattice constant of the substrate 40. For example, the second 2^{-1/2}-times lattice constant L2 is set so that the difference between the lattice constant of the superconducting layer 20 is not less than -0.5% and not more than 0.5% of the lattice constant of the superconducting layer 20.

Higher crystallinity of the superconducting layer 20 is obtained by setting the ratio Rc of the concentration of Ca to the concentration of Ba to change in the intermediate layer 30.

In the embodiment, the stacked structural body of the intermediate layer 30 and the superconducting layer 20 may be provided at two surfaces of the substrate 40.

### Third embodiment

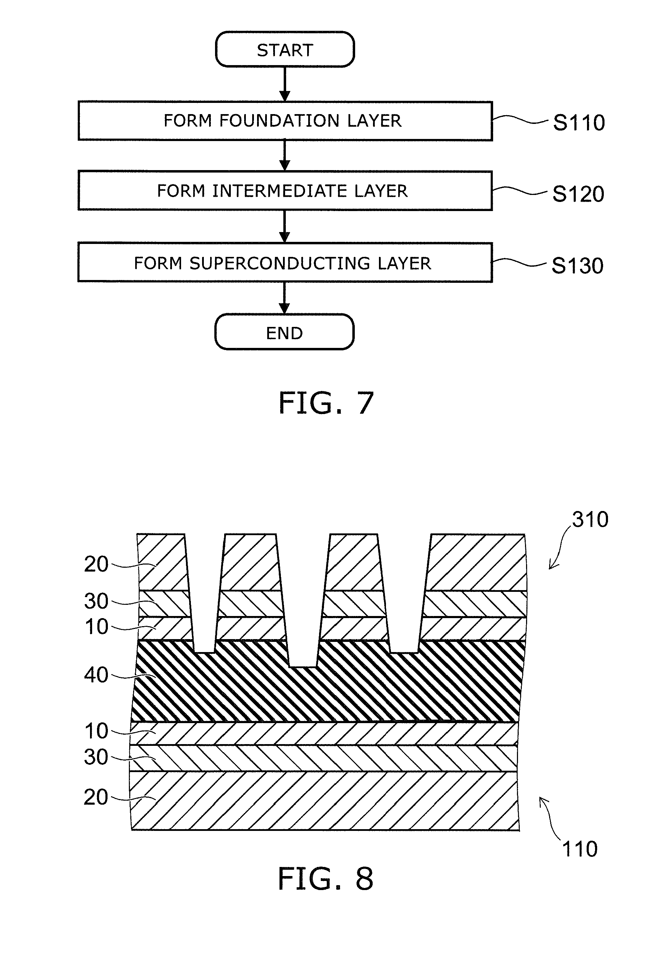

FIG. 7 is a flowchart illustrating a method for manufacturing a superconducting member according to a third embodiment.

As shown in FIG. 7, the foundation layer 10 of cerium oxide is formed on the substrate 40 of a dielectric (step S110). The intermediate layer 30 of Ba*ₓ*Ca*_{y}*CeO₃ (0.6 < *x* < 0.8 and 0.2 < *y* < 0.4) is formed on the foundation layer 10 (step S120). The superconducting layer 20 of an oxide including Cu and Ba is formed on the intermediate layer 30 (step S130). The temperature of the formation of the superconducting layer 20 is not less than 500°C and not more than 800°C.

The formation of each of the layers includes, for example, laser ablation. The formation of each of the layers may include, for example, one of sputter deposition, molecular beam epitaxy, or co-deposition.

In the embodiment, the temperature of the formation of the superconducting layer 20 can be high by forming the superconducting layer 20 on the intermediate layer 30. High crystallinity is obtained.

In the embodiment, the superconducting layer 20 is a CuBa₂Ca₃Cu₄O_{12-*z*} (0 < z < 1) layer. Or, the superconducting layer 20 is a ReBa₂Cu₃O_{7-δ} (0 < *δ* < 0.5) layer; and Re is not more than three selected from La, Y, Sm, Eu, Gd, Dy, Yb, Nd, Ho, and Er.

In the embodiment, for example, the intermediate layer 30 includes the first region p1, and the second region p2 on the first region pi. The formation of the intermediate layer 30 sets the ratio Rc of the concentration of Ca to the concentration of Ba in the second region p2 to be higher than the ratio Rc of the concentration of Ca to the concentration of Ba in the first region p1.

According to the embodiment, a method for manufacturing a superconducting member having good characteristics can be provided.

FIG. 8 is a schematic view illustrating an electronic device using the superconducting member according to the embodiment.

In the electronic device 310 of the example as shown in FIG. 8, superconducting layers are stacked on two surfaces of the substrate 40 of a dielectric; and a circuit pattern is formed by patterning one of the surfaces. Good characteristics of the electronic device 310 are obtained.

According to the embodiments, a superconducting member and a method for manufacturing the superconducting member having good characteristics can be provided.

Embodiments comprise following features:
Feature 1. A superconducting member (120), comprising:
   a substrate (40) of MgO;
   a superconducting layer (20) of an oxide including Cu and Ba; and
   an intermediate layer (30) of Ba*ₓ*Ca*_{y}*CeO₃ (0.6 < *x* < 0.8 and 0.2 < *y* < 0.4) provided between the substrate (40) and the superconducting layer (20).
Feature 2. The member (120) according to feature 1, wherein
   the intermediate layer (20) includes a first region (p1) and a second region (p2), the second region (p2) being provided between the first region (p1) and the superconducting layer (20), and
   a ratio of a concentration of Ca to a concentration of Ba in the second region (p2) is lower than a ratio of a concentration of Ca to a concentration of Ba in the first region (p1).

In the specification of the application, "perpendicular" and "parallel" refer to not only strictly perpendicular and strictly parallel but also include, for example, the fluctuation due to manufacturing processes, etc. It is sufficient to be substantially perpendicular and substantially parallel.

Hereinabove, embodiments of the invention are described with reference to specific examples. However, the invention is not limited to these specific examples. For example, one skilled in the art may similarly practice the invention by appropriately selecting specific configurations of components included in the superconducting member such as the substrate, the foundation layer, the intermediate layer, the superconducting layer, etc., from known art; and such practice is within the scope of the invention to the extent that similar effects can be obtained.

Further, any two or more components of the specific examples may be combined within the extent of technical feasibility and are included in the scope of the invention to the extent that the purport of the invention is included.

Moreover, all superconducting members and methods for manufacturing the same practicable by an appropriate design modification by one skilled in the art based on the superconducting members and methods for manufacturing the same described above as embodiments of the invention also are within the scope of the invention to the extent that the spirit of the invention is included.

Various other variations and modifications can be conceived by those skilled in the art within the spirit of the invention, and it is understood that such variations and modifications are also encompassed within the scope of the invention.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the invention.

## Claims

1. A superconducting member (110, 110a), comprising:
a superconducting layer (20) of an oxide including Cu and Ba;
a foundation layer (10) of cerium oxide; and
an intermediate layer (30) of Ba*ₓ*Ca*_{y}*CeO₃ (0.6 < *x* < 0.8 and 0.2 < *y* < 0.4) provided between the foundation layer (10) and the superconducting layer (20) .

2. The member (110, 110a) according to claim 1, wherein the superconducting layer (20) is a CuBa₂Ca₃Cu₄O_{12-*z*} (0 < *z* < 1) layer.

3. The member (110, 110a) according to claim 1, wherein
the superconducting layer (20) is a ReBa₂Cu₃O_{7-δ} (0 < δ < 0.5) layer, and
the Re is not more than three selected from La, Y, Sm, Eu, Gd, Dy, Yb, Nd, Ho, and Er.

4. The member (110, 110a) according to one of claims 1-3, wherein the intermediate layer (30) has a layer configuration.

5. The member (110, 110a) according to one of claims 1-4, wherein the superconducting layer (20) does not contact the foundation layer (10).

6. The member (110, 110a) according to one of claims 1-5, wherein the intermediate layer (30) contacts the foundation layer (10) and contacts the superconducting layer (20).

7. The member (110, 110a) according to one of claim 1-6, wherein a thickness of the intermediate layer (30) is not less than 0.5 times and not more than 3 times a thickness of the foundation layer (10).

8. The member (110, 110a) according to one of claims 1-7, wherein a total thickness of the foundation layer (10) and the intermediate layer (30) is not less than 50 nanometers and not more than 200 nanometers.

9. The member (110, 110a) according to one of claims 1-8, wherein a ratio of a concentration of Ca to a concentration of Ba in the intermediate layer (30) is not less than 0.43 and not more than 0.5.

10. The member (110, 110a) according to one of claims 1-9, wherein a ratio of a concentration of Ca to a concentration of Ba in the intermediate layer (30) changes in a stacking direction from the foundation layer (10) toward the superconducting layer (20).

11. The member (110a) according to one of claims 1-10, wherein
the intermediate layer (30) includes a first region (p1) and a second region (p2), the second region (p2) being provided between the first region (p1) and the superconducting layer (20), and
a ratio of a concentration of Ca to a concentration of Ba in the second region (p2) is higher than a ratio of a concentration of Ca to a concentration of Ba in the first region (p1).

12. The member (110a) according to claim 11, wherein
the ratio of the concentration of Ca to the concentration of Ba in the second region (p2) is not less than 0.43 and not more than 0.47, and
the ratio of the concentration of Ca to the concentration of Ba in the first region (p1) is not less than 0.46 and not more than 0.50.

13. The member (110, 110a) according to claim 1, further comprising a substrate (40) of a dielectric,
the foundation layer (10) being disposed between the substrate (40) and the intermediate layer (30).

14. The member (110, 110a) according to claim 13, wherein the substrate (40) is a sapphire substrate.

15. A method for manufacturing a superconducting member (110, 110a), comprising:
forming a foundation layer (10) of cerium oxide on a substrate (40) of a dielectric;
forming an intermediate layer (30) of Ba*ₓ*Ca*_{y}*CeO₃ (0.6 < x < 0.8 and 0.2 < *y* < 0.4) on the foundation layer (10); and
forming a superconducting layer (20) of an oxide including Cu and Ba on the intermediate layer (30).

16. The method according to claim 15, wherein the superconducting layer (20) is a CuBa₂Ca₃Cu₄O_{12-*z*} (0 < *z* < 1) layer.

17. The method according to claim 15, wherein
the superconducting layer (20) is a ReBa₂Cu₃O_{7-δ} (0 *< δ* < 0.5) layer, and
the Re is not more than three selected from La, Y, Sm, Eu, Gd, Dy, Yb, Nd, Ho, and Er.

18. The method according to one of claims 15-17, wherein
the intermediate layer (30) includes a first region (p1), and a second region (p2) provided on the first region (p1), and
the forming of the intermediate layer (30) includes setting a ratio of a concentration of Ca to a concentration of Ba in the second region (p2) to be higher than a ratio of a concentration of Ca to a concentration of Ba in the first region (p1).
